# EUROPEAN PATENT SPECIFICATION

(11) **EP 0 393 620 B1**
(45) Date of publication and mention of the grant of the patent: **22.10.1997**
(21) Application number: 90107341.1
(22) Date of filing: 18.04.1990
(51) Int. Cl.: H01L 27/118

(54) **Semiconductor device**
Halbleiteranordnung
Dispositif semi-conducteur

(30) Priority: 19.04.1989 JP 99130/89; 19.05.1989 JP 125839/89; 07.02.1990 JP 27785/90
(43) Date of publication of application: 24.10.1990
(60) Divisional application: 96101001.4
(73) Proprietor: SEIKO EPSON CORPORATION, Shinjuku-ku Tokyo-to (JP)
(72) Inventor: Sakuda, Takashi, c/o Seiko Epson Corporation, Suwa-shi, Nagano-ken (JP); Ohkawa, Kazuhiko, c/o Seiko Epson Corporation, Suwa-shi, Nagano-ken (JP); Oguchi, Yasuhiro, c/o Seiko Epson Corporation, Suwa-shi, Nagano-ken (JP); Hirabayashi, Yasuhisa, c/o Seiko Epson Corporation, Suwa-shi, Nagano-ken (JP)
(74) Representative: Hoffmann, Eckart, Dipl.-Ing.

(56) References cited:
- PATENT ABSTRACTS OF JAPAN, vol. 10, no. 192 (E-417)[2248], 5th July 1986; & JP-A-61 035 535
- THE PROCEEDINGS OF THE 1ST INTERNATIONAL CONFERENCE ON SEMI-CUSTOM IC'S, London, November 1981, pages 65-74, Mackintosh Publications Ltd, Luton, GB; T. GILES: "Philips PCF700 series LOCMOS gate arrays"

## Description

### Field of the Invention

The present invention relates to semiconductor devices. More specifically, the present invention pertains to semiconductor devices which comprise closely spaced gate arrays having a plurality of unit semiconductor devices of gate-separated type insulated-gate field-effect transistors, the gates of which have an improved configuration.

### Related Art Description

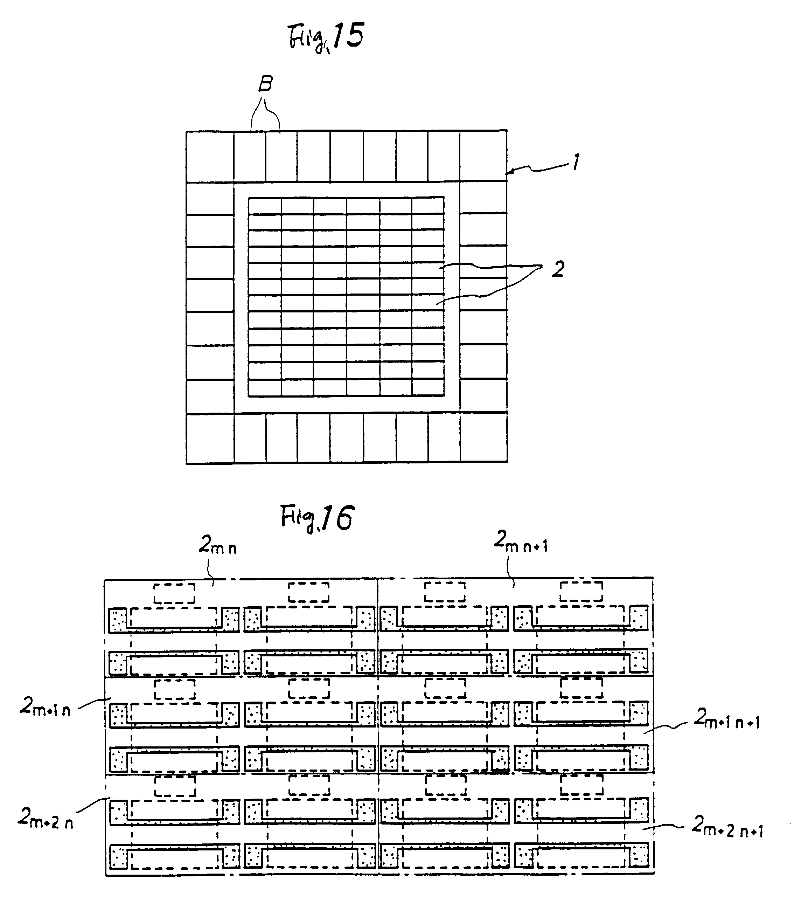

Conventional semiconductor chip products of the channelless gate array type have such an inner layout as shown in Figure 15, in which a matrix of a plurality of gate-separated type unit semiconductor devices 2 is disposed on a silicon chip substrate 1 with a plurality of input/output buffer portions B along the peripheral area of the chip substrate so that they surround the matrix of the unit devices. Figure 16 illustrates a portion of the matrix in an enlarged scale. In this type of gate array, insulated-gate field-effect transistors in the same unit devices are connected with each other and/or those belonging to different unit devices are connected by means of a first and/or second layers of aluminum wire deposited on the gate array, so that a desired large-scale logic circuitry can be obtained.

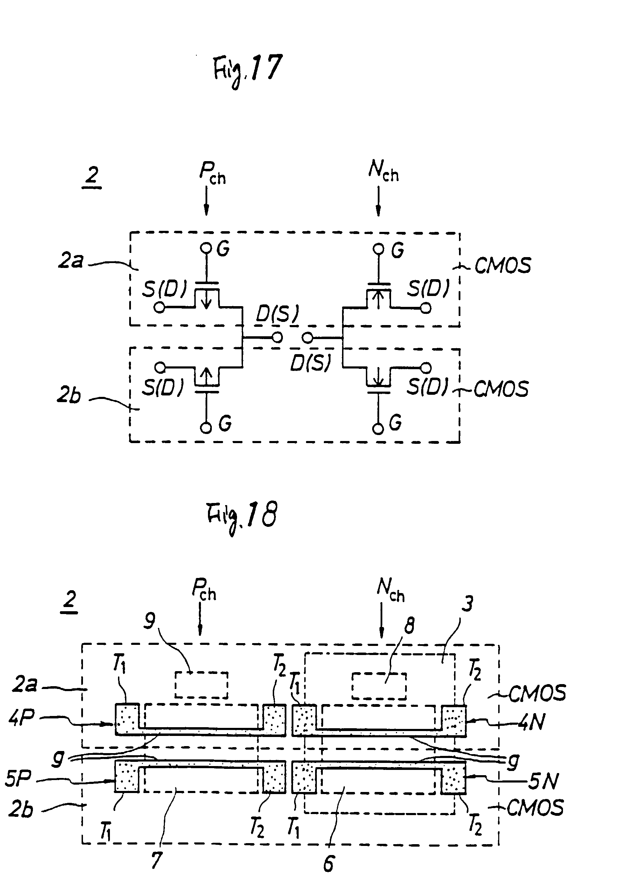

Figure 17 is a block diagram of the unit device of the gate-separated type. The unit device 2 is comprised of two pairs of complementary insulated-gate field-effect transistors 2a and 2b of the gate-separated type ( hereinafter referred to as "CMOSFET"). The gates G of the COMSFETs are independent of one another, whereas the FETs of the same conductivity type have a common drain D or source S. Figure 18 illustrates a conventional structure of the gate-separated unit device 2. shown in this Figure, an N-type substrate is formed with a rectangular-shaped region of a P-type well 3 which is formed by diffusing P-type impurities in the substrate. Polysilicon gates 4N, 5N are formed in the P-type well 3 via a gate oxide film so that they are across the P-type well and are symmetrical with each other. Adjacent to the P-type well 3 another pair of polysilicon gates 4P and 5P are formed at the parallel moved positions of the respective gates 4N and 5N in the channel width direction. A heavily diffused N-type region 6 is formed in a self-aligned manner by ion implantation of N-type impurities into the P-type well with utilization of the pair of polysilicon gates 4N and 5N. Likewise, heavily diffused P-type region 7 is formed in a self-aligned manner by ion implantation of P-type impurities into the N-type substrate with utilization of the pair of polysilicon gates 4P and 5P. addition, a heavily doped P-type stopper 8 is provided by diffusion adjacent to the region 6 in order to supply voltage V _{DD} to the N-type substrate, and a heavily doped N-type stopper 9 is disposed adjacent to the region 7, the stopper 9 being for supplying voltage V_{SS} to the P well.

Each of the polysilicon gates 4N, 5N, 4P and 5P are of U-shaped configuration comprising a narrow width gate electrode portion g and rectangular gate output terminal portions T1 and T2 extended form the both ends of the gate electrode portion g. Regions just below the respective gate electrode portions g function as channels. Region, which is located in the heavily diffused N-type region 6 between the parallel disposed gate electrode portions g, functions as a common drain or source region for the two N-channel MOSFETs. The common drain or source region for the two P-channel MOSFET is likewise located between the parallel disposed gate electrode portions g in the heavily diffused P-type region 7.

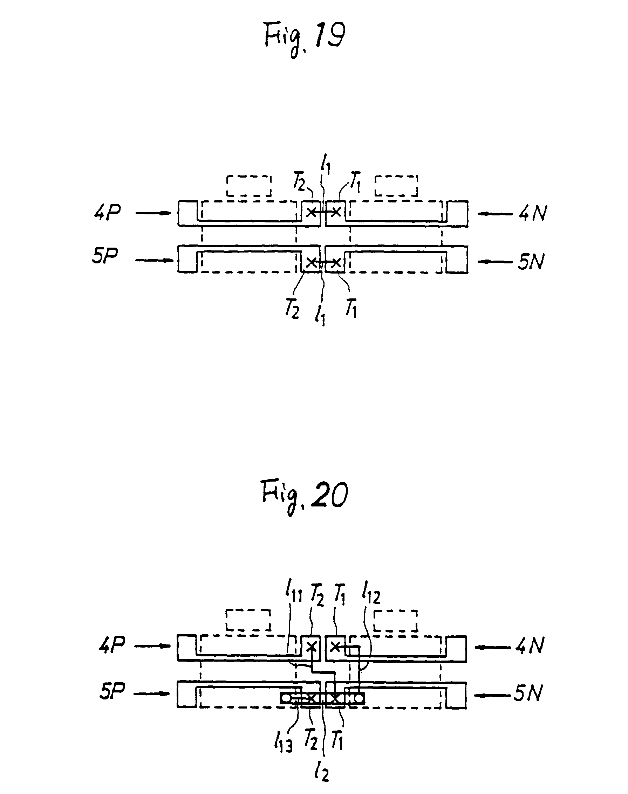

In the gate array of the above-mentioned gate-separated unit devices 2, as shown in Figure 19, the adjacent CMOSFETs of the same unit device are wired between their gates oppositely arranged with each other so that the gate output terminal portions T1 and T2 thereof are connected via the aluminum wire l1 (shown by solid line) of a first layer through contact holes ( denoted by "X" in the drawing), said first layer being laid on the gates, whereby the shortest wire-connection between the adjacent CMOSFETs can be achieved. The diagonal wire connection between terminal portions T1 and T2 in the same unit device can be obtained as shown in Figure 20, wherein one pair of diagonally positioned terminal portions T1 and T2 are connected by means of the aluminum wire l11 of a first layer through contact holes. Whereas, the other pair of diagonally positioned terminal portions T1 and T2 are connected by means of aluminum wires l12 and l13 of the first layer and the aluminum wire l2 (shown by double solid line) of a second layer laid on the first layer through contact holes and connecting portions denoted by "O". The separated-type unit device has benefits that it can easily be modified to a common-gate type unit device by such a wiring as shown in Figure 19 and that it can be applied with the diagonal wiring as shown in Figure 20 which is not applicable to the common-gate type unit device. Especially, the applicability of the diagonal wiring is useful to compose functional devices such as transmission gates and the like.

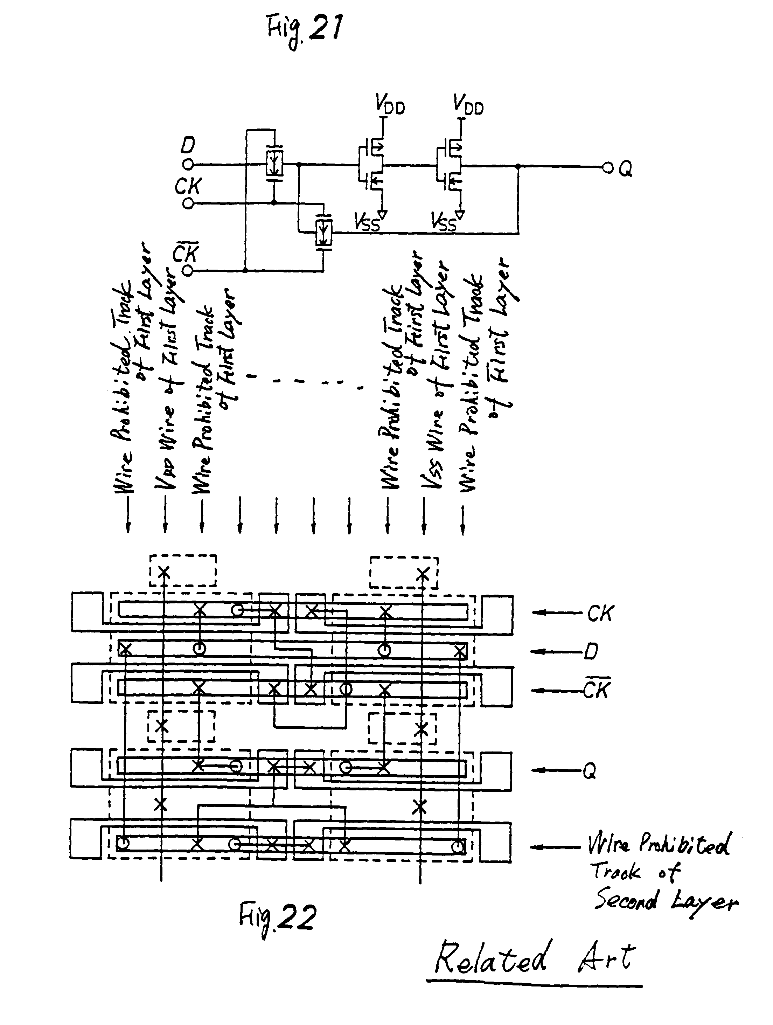

However, the diagonal wiring requires a second or more layered aluminum wires in the case that the wire length is intended to be as short as possible. If the second layered aluminum wires l2 are arranged for connection among the elements within the unit devices, the regions occupied by these second layered wires cannot be utilized to arrange another wires for connection among the remotely positioned functional unit devices and among the functional unit devices and the input/output buffers, thus those regions are called a "wire prohibited track". Therefore, outer wiring feasibility (defined as ease of wiring among the remotely positioned functional unit devices and among the functional unit devices and the input/output buffers) becomes degraded as the number or area of the inner wires of the second or more layers increases. For example, a D flip-flop shown in Figure 21 can be constituted by two unit devices 2. In this case, "wire prohibited tracks" occur on the second layer of aluminum as shown in Figure 22 due to the diagonal wiring among the inner elements, so that the outer wiring feasibility becomes degraded.

It is of course possible that the two unit devices can be connected without using second layered aluminum wires. However, in this case, the respective aluminum wires of the first layer must be arranged so that they do not cross one another, which means that the total wire length becomes longer, so that the occupied regions for those long wires becomes larger. This degrades inner wiring feasibility (defined as ease of wiring among the elements in each of the unit devices and among the adjacent unit devices). If the first layered wires become complicated and elongated, wire resistance and wire capacity caused by increase of wired area will increase, and so wire time constant will become larger. This will cause a noticable amount of delay in the device operation.

A semiconductor device according to the pre-characterizing portion of claim 1 is disclosed in the documents Patent Abstracts of Japan, Vol.10, No.192 (E-417)[2248], July 1986; & JP-A-61 35535 and The Proceedings of the 1st International Conference on Semi-Custom IC's, London, Nov. 1981, pages 65-74.

### SUMMARY OF THE INVENTION

Accordingly, it is an object of the present invention to provide a unit semiconductor device of the gate-separated type of which gates are designed to have an improved profile, whereby adjacent gates in the unit device can be diagonally connected by using first layered wires only without increase of the wire length.

It is an another object of the present invention to provide a semiconductor device which comprises a gate array of a plurality of unit semiconductor devices having gates of an improved profile to thereby enhance the inner wiring feasibility thereof as well as the outer wiring feasibility.

These objects are achieved with a semiconductor device as claimed in claim 1.

Preferred embodiments of the invention are subject-matter of the dependent claims.

The respective gate electrodes are usually made by polysilicon in consideration of self-alinged formation of their source or drain regions. The remaining region of the semiconductor substrate, which does not contribute substantially to the formation of a channel inverted layer, is utilized as the site on which gate terminal portions of the gate electrodes are disposed. The gate terminal portions can be a layer deposited on the layer of the gate electrodes, which, however, requires another process in addition to the gate electrode forming process. Hence, it is recommendable to form the gate terminal portions in the same layer of the gate electrodes at the same time the gate electrodes are formed.

Typical semiconductor devices of master slice layout are provided with gate electrodes designed to have a profile of short channel length and wide channel width in order to decrease on-resistance value. On the other hand, automatic wiring process is usually utilized to connect among the elements in the unit devices and among the unit devices, wherein wires are arranged along the longitudinal and lateral directions of the grids, and therefore the first and second insulated-gate field-effect transistors are needed to arrange such that the channel regions (the gate electrodes) of the respective transistors are oriented in the same direction, either the longitudinal direction or the lateral direction of the grids. The channel regions of the respective transistors may be arranged between the same longitudinal or the same lateral line of the grids, or they may be in the adjacent, parallel grid lines, respectively.

As mentioned above, the gate terminal portions are formed on regions other than those for source or drain, and the gate electrodes are usually of a narrow width shape. The gate terminal portions formed at both ends of the gate electrode are wide in the channel length direction compared to the gate electrode. In this case, the gate terminal portions are generally designed to have a minimum area of one-grid square.

It is apparent that inner and outer wiring feasibilities are improved as the number of wires which can be connected with the gate terminal portions. The increase in the number of wires, however, means that the gate terminal portions become an increased area, which causes degradation in element-integrity of semiconductor devices. In automatic wiring of the gate terminal portions, wires are arranged along the longitudiral and lateral grid lines. Therefore, the gate terminal portions are preferably designed such that they are able to be connected with wires of different grid lines. Thus, in an embodiment of the present invention, there is Drovided a semiconductor device wherein gate electrodes of unit semiconductor devices are formed at one end with a gate terminal portion of rectangular shape, characterized in that wire junction portions are provided in the regions surrounded by four gate terminal portions, each of the wire junction portions having an area of at least three-grid. The wire junction portions are preferably formed in the same layer of the gate electrodes by polysilicon or the like.

According to the present invention, each of the gate terminal portions comprises the second wire connecting portion as well as the first wire connecting portion. The second connecting portions can be, for example, used to connect wires of the first layer through contact holes, by which wire length can be reduced in comparison with using only the first connecting portions for wiring. Hence, the unit devices can be diagonally connected as described before, using wires of only the first layer in such a manner that the wire length is not increased. By this short wiring, the delay time caused by the wiring is reduced, and the inner wiring feasibility is improved. In addition, since the second connecting portions can be utilized for passage of wires of the first layer, wires of the second layer are required in less number, and wire prohibited tracks are reduced in number, whereby the outer wiring feasibility can be enhanced.

Where the gate terminal portions are of a crank shape, the diagonal wiring among the gate terminal portions can be achieved by using only wires of the first layer arranged within the areas on the adjacent gate terminal portions.

While, where the gate terminal portions are of the rectangular shape and the wire-junction portions are provided, the diagonal wiring among the gates is carried out by connecting wires of the first layer to the both ends of the wire-junction portions via contact holes, while other wires of the first layer can be arranged to pass on the middle of the wire-junction portions. According to the arrangement, wires of the first layer which are required for the diagonal wiring do not project onto the source or drain regions. In addition, where the adjacent gate terminal portions are connected, it is possible to make a space between the wires connecting gate terminal portions. The space can be utilized to arrange other wires of the first layer.

### BRIEF DESCRIPTION OF THE DRAWINGS

The above and other objects and advantages of the present invention will be apparent from the following detailed description with reference to the attached drawings, in which:
Figure 1 is a diagram illustrating an array of gate-separated type unit devices not covered by the present invention;
Figure 2 is a plan view of the unit device in an enlarged scale of Figure 1;
Figure 3A is a cross-sectional view of the unit device taken along line A-A in Figure 2;
Figure 3B is a cross-sectional view of the unit device taken along line B-B in Figure 2;
Figure 4 is a layout of the gate-separated type unit device of Figure 2;
Figure 5 illustrates one mode of wiring between gates positioned adjacent to each other in the lateral direction in the gate-separated type unit device in Figure 2;
Figure 6 illustrates diagonal wiring between adjacent gates in the gate-separated type unit device in Figure 2;
Figure 7 is a plan view of a D flip-flop constituted by two unit devices;
Figure 8 is a diagram illustrating an array of gate-separated type unit devices of an embodiment of the present invention;
Figure 9 is a plan view of the unit device in an enlarged scale of Figure 8;
Figure 10 is a layout of the gate-separated type unit device of Figure 9;
Figure 11 illustrates one mode of wiring between gates positioned adjacent to each other in the lateral direction in the gate-separated type unit device of Figure 9;
Figure 12 illustrates another mode of wiring between gates positioned adjacent to each other in the lateral direction in the gate-separated type unit device in Figure 9, in which the gates are not provided with second wire connecting portions not covered by the present invention;
Figure 13 illustrates one mode of wiring between diagonally positioned gates in the gate-separated type unit device of Figure 9;
Figure 14 is a plan view of a D flip-flop constituted by two unit devices of the embodiment of the present invention;
Figure 15 is a schematic plan view showing an inner structure of a semiconductor chip of a conventional channelless-type gate array;
Figure 16 illustrates an array of gate-separated type unit device of Figure 15;
Figure 17 is a circuit diagram of the unit device of Figure 15;
Figure 18 is an enlarged plan view of the unit device of Figure 15;
Figure 19 shows an example of wiring between the gates positioned adjacent to each other in the lateral direction in the unit device of Figure 15;
Figure 20 shows an example of wiring between the gates diagonally positioned in the unit device of Figure 15;
Figure 21 is a circut diagram of a D flip-flop composed by MOSFETs; and,
Figure 22 shows an example of wiring between two unit devices of Figure 15 to compose a D flip-flop.

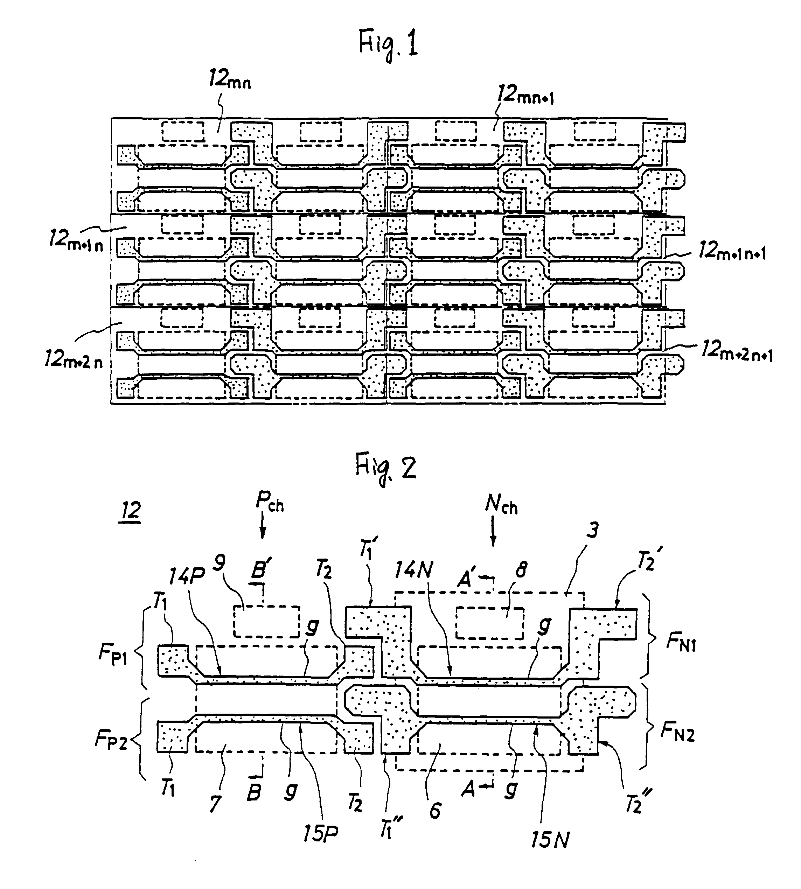

As shown in Figs. 1-4, a plurality of unit semicondutor devices 12 of gate-separated type are arranged along the longitudinal and lateral directions at the same intervals to form a matrix of the unit devices. Each of the unit devices 12 has a plane structure comprising a pair of N-channel MOSFETs (F_{N1}, F_{N2}) arranged parallel to each other and a pair of P-channel MOSFETs (F_{P1}, F_{P2}) arranged parallel to each other and positioned adjacent to the respective N-channel MOSFFETs. The region in which the N-channel MOSFETs are formed is provided with a square region of P well 3 by diffusing P-type impurities into an N-type silicon substrate 20 of low dense impurities. A pair of polysilicon gates 14N and 15N are formed in parallel with each other on the P-type well 3 via gate oxide film 13. A high dense N-type diffused region 6 is formed in a self-aligned manner by ion implantation of N-type impurities with utilizing the polysilicon gates 14N and 15N as masks, this region 6 being source or drain region. Adjacent to the high dense diffused region, a high dense P-type stopper 8 is formed by diffusion which is used for supplying voltage V_{SS} to the P well 3. In addition, oxide films 10 are deposited thickly and partially on the P-type well 3. Likewise, the region in which the P-channel MOSFETs (F_{P1}, F_{P2}) are formed is provided with a pair of polysilicon gates 14P and 15P which are formed in parallel with each other on the substrate adjacent to the P well 3 via the gate oxide film 13. A high dense P-type diffused region 7 is formed in a self-aligned manner by ion implantation of P-type impurities with utilizing the polysilicon gates 14P and 15P as masks, this region 7 being source or drain region. Adjacent to the high dense diffused region, a high dense P-type stopper 9 is formed by diffusion which is used for supplying voltage V _{DD} to the N-type substrate 20. In addition, oxide films 10 are deposited thickly and partially on the P-type well 3.

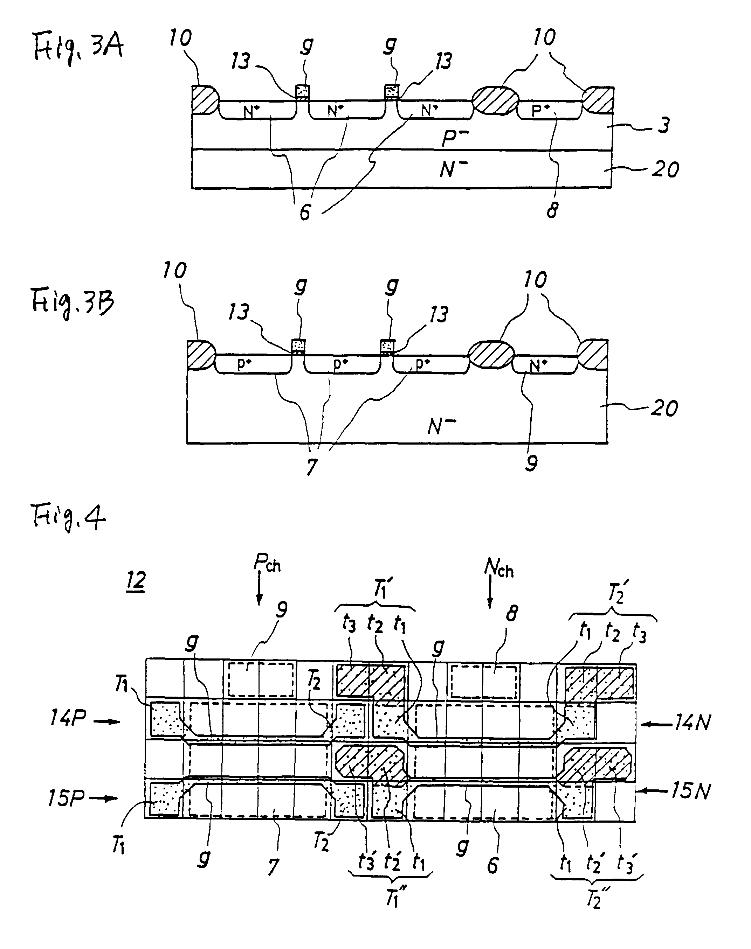

The polysilicon gates 14P and 15P are shaped to be a substantially flat U-shape and are arranged symmetrically. As shown in Figure 4, each of the polysilicon gates 14P and 15P comprises a narrow width gate electrode g of four-grid length and gate terminal portions T1 and T2 which are integrally connected to both ends of the gate electrode g and are of rectangular shape having an area of one-grid square. The gate terminal portions T1 and T2 have an area sufficient for a single wire connection, that is, for wiring via a single contact hole to form ohmic contact. The regions just below the gate electrodes g, g apart from each other by one-grid distance are for channel regions of four-grid width. Among those, the region between the gate electrodes g, g in the high dense N-type diffused region 7 is utilized as a common source or drain region for the two P-channel MOSFETs. These drain or source regions for the P-channel MOSFETs have four wire connecting positions arranged in the channel width direction, and the stopper 9 has two wire connecting positions arranged in the same direction.

The polysilicon gates 14N and 15N are formed at the positions the polysilicon gates 14P and 15P moved laterally by a predetermined distance. The gates 14N and 15N have a different shape from the gates 14P and 15P, that is, the gate 14N has a portion of the same shape as of the gate 14P and a portion denoted by oblique lines in Figure 4 integrally added to the former. In other words, the gate 14N comprises a narrow gate electrode portion g of about four-grid length and crank-shaped gate terminal portions T1' and T2' integrally connected to both ends of the gate electrode portion g. The terminal portion T1' adjacent to the gate 14P comprises a first wire connecting position t1 of one-grid square corresponding to the terminal portion T1 of the gate 14P, a second wire connecting position t2 of one-grid square extending from the first terminal position t1 in the channel length direction and a third wire connecting position t3 of one-grid square which is extended from the position t2 in the channel width direction towards the gate 14P and located adjacent to the terminal portion T1 of the gate 14P. The terminal portion T2' opposite to the terminal portion T1' comprises a first wire connecting position t1 of one-grid square corresponding to the terminal portion T2 of the gate 14P, a second wire connecting position t2 of one-grid square extending from the first terminal position t1 in the channel length direction and a third wire connecting position t3 of one-grid square which is extended outwardly from the position t2 in the channel width direction. The second and third wire connecting positions t2 and t3 denoted by oblique lines in Figure 4 are located on the same grid line on which the stoppers 8 and 9 are located. The gate 14N itself is shaped symmetrically with respect to the line passing through the center thereof in the channel width direction.

The gate 15N is provided with a terminal portion T1" adjacent to the gate 15P, the terminal portion T1" comprising a first wire connecting position t1 of one-grid square corresponding to the terminal portion T1 of the gate 15P, a second wire connecting position t2' of one-grid square extending from the first terminal position t1 in the channel length direction and a third wire connecting position t3' of one-grid square which is extended from the position t2' in the channel width direction toward the gate 14P and located between the terminal portions T2 of the respective gates 14P and 15P. The terminal portion T2" opposite to the terminal portion T1" comprises a first wire connecting position t1 of one-grid square corresponding to the terminal portion T2 of the gate 15P, a second wire connecting position t2' of one-grid square extending from the first terminal position t1 in the channel length direction and a third wire connecting position t3' of one-grid square which is extended outwardly from the position t2' in the channel width direction. The second and third wire connecting positions t2' and t3' denoted by oblique lines in Figure 4 are located on the grid line between the parallel gates g, g. The gate 15N itself is shaped symmetrically with respect to the line passing through the center thereof in the channel width direction. In addition, the wire connecting positions t2' and t3' of the gate 15N are formed to have the chamfered shape of the wire connecting positions t2 and t3.

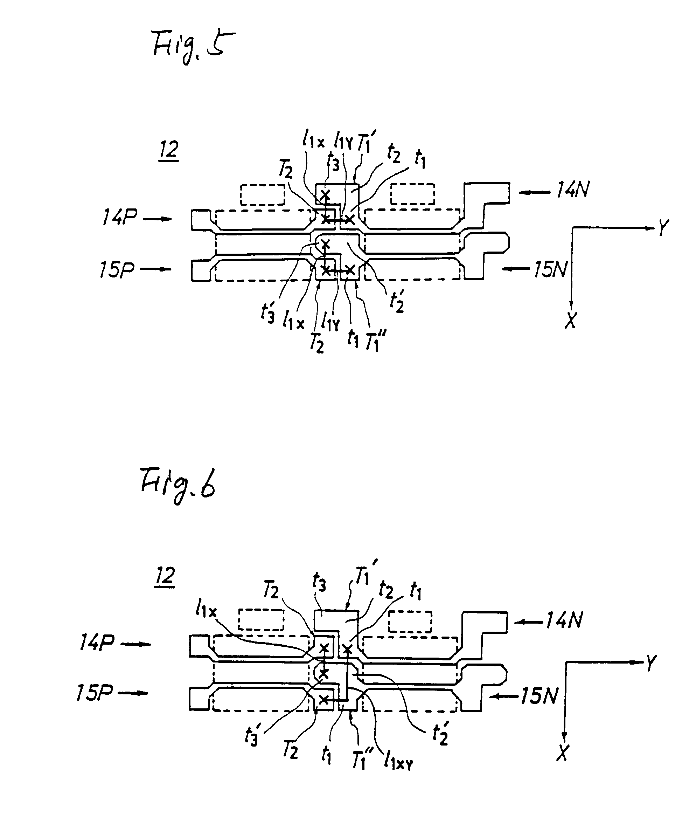

The terminal portions T2 and T2 of the gates 14P and 15P can be connected to the terminal portions T1' and T1" in the following two wiring manners as shown in Figure 5. A first wiring manner is such that the terminal portions T2 and T2 are connected via contact holes (shown by 'X') with the terminal portions T1' and T1" by means of an aluminum wire ℓ_{1Y} of the first layer arranged along Y grid direction. The other wiring manner is such that the terminal portions T2 and T2 are connected via contact holes (shown by 'X') with the terminal portions T1' and T1" at their third connecting positions t3 by means of an aluminun wire ℓ_{1X} of the first layer arranged in X grid direction normal to Y grid direction. Thus, where a pair of adjacent gate-separated type CMOSFETs in the same unit device are connected with each other to form a common gate, two ways of the shortest wiring can be obtained with utilizing only the wires of the first layer having one-grid length. This means that the wiring feasibility is extremely enhanced compared to the conventional devices. The space occupied by the unit device 12 of the present embodiment is four-grid long in X direction by twelve-grid wide in Y direction and so, is the same as that of the prior unit devices of Figure 18. The unit devices of the present embodiment are characterized by adding the second and third wire connecting positions t2, t3, t2' and t3' to the gates 14N and 15N designated by oblique lines in Figure 4 which are located in unused regions of the grid line in which the stoppers 8 and 9 and of the grid line in which the common region of the source or drain are situated. Therefore, increase in the area of the unit devices can be avoided in the present embodiment.

Next, the diagonal wiring of the gates in the unit device 12 can be carried out as shown in Figure 6, wherein the terminal portion T2 of the gate 14P is connected to the terminal portion T1" and the portion T2 of the gate 15P to the portion T1' of the gate 14N. In the illustrated diagonal wiring, the terminal portion T2 is connected to the adjacent terminal portion T1" of the gate 15N at its third wire connecting portion t3' by means of an aluminum wire ℓ ₁ₓ of the first layer arranged along the longitudinal grid line (X grid-direction), whereas the terminal portion T2 of the gate 15P is connected to the terminal portion T1' of the gate 14N at its first wire connecting position t1 by means of an aluminum wire ℓ _{1XY} of the first layer arranged so that it passes on the first and second wiring positions t1 and t2' of the terminal portion T1" in this order. In the present embodiment, a space of three-grid length in X direction by two-grid width in Y direction is defined by the terminal portions T2 of the respective gate 14P and 15P, the terminal portion T1" of the gate 15N, and the first wire connecting positions t1 of the terminal portions T1" and T1' of the respective gates 15N and 14N, in which space the diagonal wiring among the gates can be perfomed by the aluminum wires of the first layer without utilizing aluminum wires of the second layer deposited on the first aluminum layer. The benefits obtained from using only the first aluminum layer are that wire prohibited tracks occurring due to the use of second aluminum layer can be avoided, which contributes to enhancement of the outer wiring feasibility. As shown in Figure 20, according to the prior wiring, it is inevitable to arrange the aluminum wires ℓ ₁₃ and ℓ ₂ of the first and second layers one on the other in the opposite directions and to arrange wires such as the aluminum wire ℓ ₁₂ to the extent on the gate electrodes g and so, the wires cannot be arranged within the space of three-grid length by two-grid width. In contrast, according to the present embodiment, since aluminum wires of the second layer do not need to be utilized and wires do not go over the gate electrodes g, the wiring length can be reduced. Therefore, the capacity and resistance caused by wiring can be reduced at the same time, and the inner wiring feasibility can be enhanced as well as the delay time caused by the wiring can be reduced.

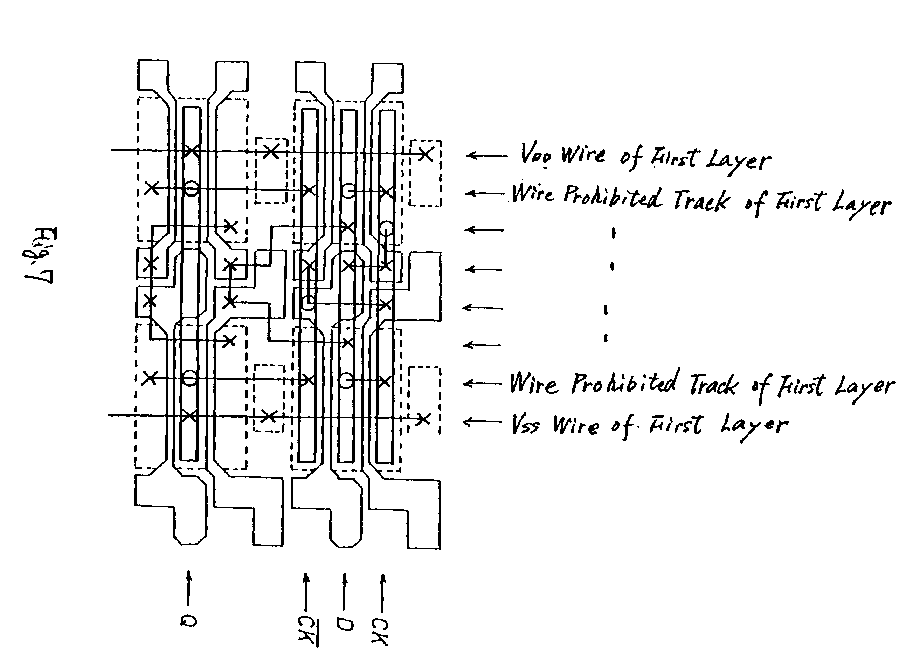

Figure 7 illustrates a D flip-flop comprised by two unit semiconductor devices of the present embodiment, the flip-flop being the same as that of Figure 22. It should be noted in Figure 7 that the wiring length is extremely reduced and that no prohibited tracks of the second wires occur. The terminal portions T1', T2', T1" and T2" of the respective gate 14N and 15N are all provided with the second and third wire connecting positions. Alternatively, as is apparent from the wiring illustrated in Figure 6, unit devices without terminal portions T1', T2' and T2" of the respective gates 14N and 15N can be used to thereby enhance the inner and outer wiring feasibilities in comparison with those of the prior art unit devices.

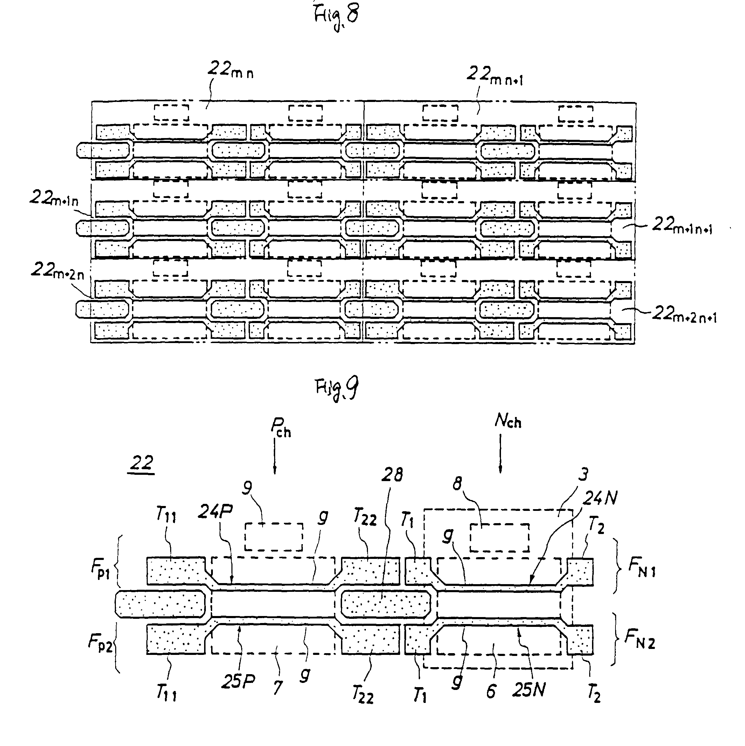

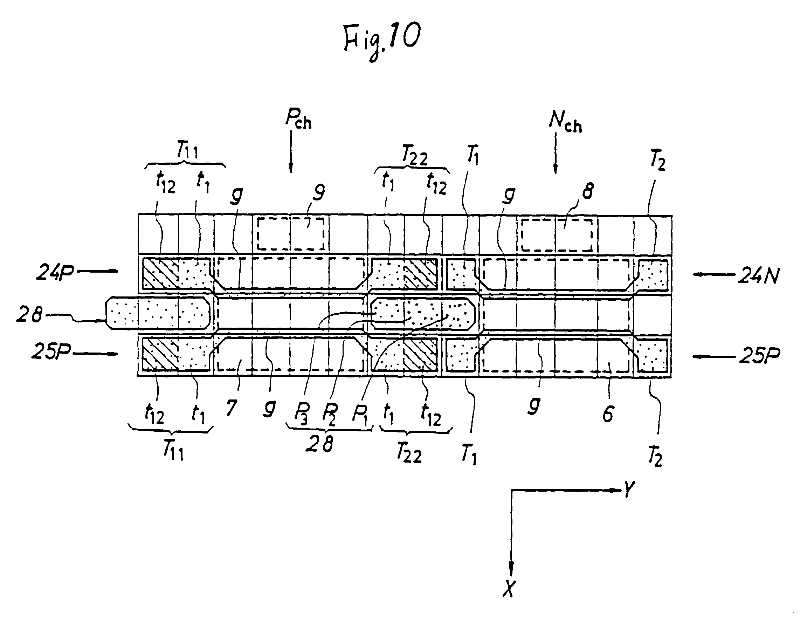

Figures 8 to 10 illustrate an embodiment of the present invention, in which elements corresponding to the above-mentioned embodiment are designated by the same reference numerals. As shown in Figure 8, a plurality of unit semicondutor devices 22 are arranged to form a matrix. Each of the unit semicondutor devices 22 is illustrated in Figure 9. The unit semicondutor device 22 comprises a pair of parallel N-channel MOSFETs (F_{N1}, F_{N2}) and a pair of parallel P-channel MOSFETs (F _{P1}, F _{P2}). The N-channel MOSFETs have polysilicon gates 24N and 25N, respectively, which are of a substantially flat U-shape and are disposed symmetrically with each other. As shown in Figure 10, each of the polysilicon gates 14N and 15N comprises a narrow gate electrode portion g of about four-grid length and terminal portions T1 and T2 of one-grid square integrally connected to the both ends of the gate electrode g. The terminal portions T1 and T2 have an area sufficient for wiring via a single wire connecting position, that is, a single contact hole. The gate electrodes g are spaced by one-grid distance, below which channel regions of four-grid length are formed. Among these, the channel region between the parallel gate electrodes g, g in the high dense N-type diffused region 6 is a common drain or source region for the N-channel MOSFETs.

While, polysilicon gates 24P and 25P of the P-channel MOSFETs are substantially of a flat U-shape and disposed on the positions the polysilicon gates are moved laterally by a predetermined distance. The gates 24P and 25P are designed to have a shape different from the gates 24N and 25N. The gate 24P comprises a portion having the same shape as that of the gate 24N and a portion denoted by oblique lines in Figure 10. That is, the gate 24P comprises a narrow width gate electrode portion g of substantially four-grid length and rectangular terminal portions T11 and T22 of two-grid in area. The terminal portion T22 is located adjacent to the gate 24N and is comprised by a first wire connecting positiont1 of one-grid square corresponding to the terminal portion T2 of the gate 24N and a second wire connecting position t12 of one-grid square extending outwardly in the channel width direction from the first wiring position t1. The other terminal portion T11 is comprised by a first wire connecting position t1 of one-grid square corresponding to the terminal portion T1 of the gate 24N and a second wire connecting position t12 of one-grid square extending outwardly in the channel width direction from the first wire connecting position t1.

Likewise, the gate 25P adjacent to the gate 25N has a terminal portion T22 which comprises a first wire connecting position t1 of one-grid square corresponding to the terminal portion T2 of the gate 25N and a second wire connecting position t12 of one-grid square extending outwardly in the channel width direction from the first wire connecting position t1. The terminal portion T11 located opposite to the portion T22 comprises a first wire connecting position t1 of one-grid square and a second wire connecting position t12 of one-grid square extending outwardly in the channel width direction from the first wire connecting position t1. By adding the second wire connecting position t12, the gates 24P and 25P are eight-grid long in the channel width direction. A region is defined by the surrounding terminal portions T1, T1, T22, T22 of the gates 24N, 25N, 24P and 25P, in which an isolated wire junction area 28 is arranged. The wire junction area 28 is formed at the same time the gates are formed and so, is formed by polysilicon doped with impurities. The wire junction area 28 has a first wire-junction position P1 between the terminal portions T1 and T1, a second wire-junction position P2 between the second wire connecting positions t12 and t12, and a third wire-junction position P3 between the first wire connecting positions t1 and t1.

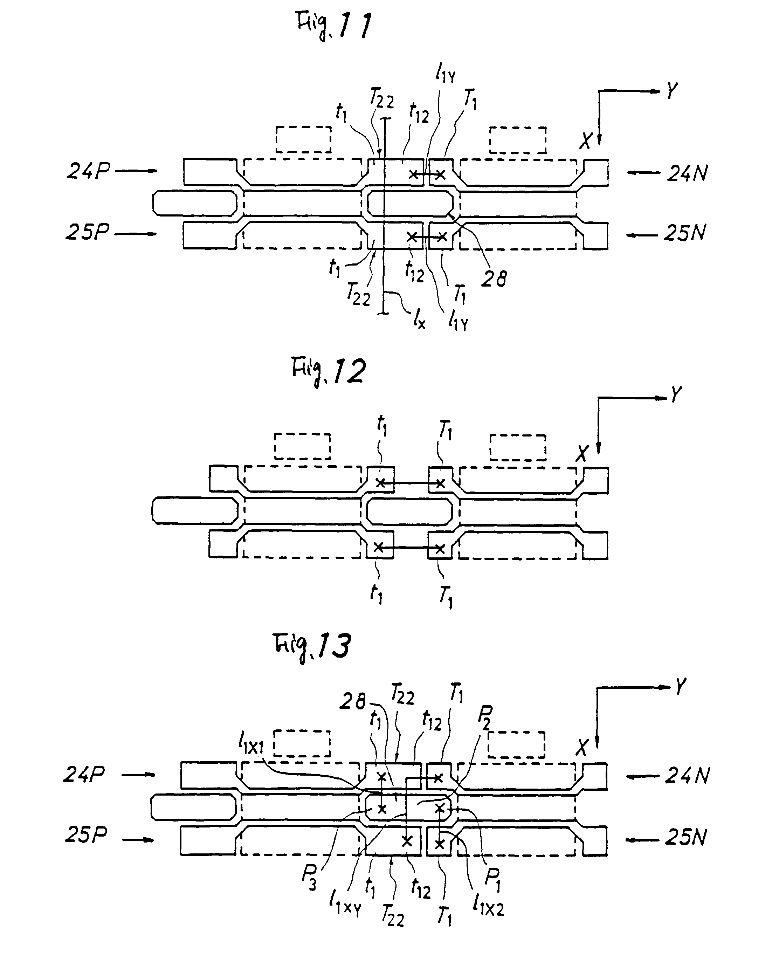

In the unit semiconductor device of the above structure, the gates 24P and 25P are connected to the adjacent gates 24N and 25N as shown in Figure 11, wherein the second wire connecting positions t12 and t12 of the respective gates 24P and 25P are connected via contact holes designated by 'X' to the terminal portions T1 and T1 of the gates 24N and 25N by means of aluminum wires ℓ _{1Y} of the first layer arranged laterally (along Y-grid direction). The lateral wiring among the gates can be perfomed by the shortest wires, that is, one-grid long wires. In addition, the first wire connecting positions t1 and t1 remain unused and so, an aluminum wire ℓₓ can be arranged in the longitudinal direction (X-grid direction) passing therethrough. In contrast, where the terminal portions T1 and T1 of the gates 24P and 25P are not provided with the second wire connecting position t12 and t12 of one-grid square as shown in Figure 12, there is no space to pass an aluminum wire in the X direction between the adjacent terminal portions, which means that a wire prohibited track of three-grid length occurs between the adjacent terminal portions in the first aluminum layer.

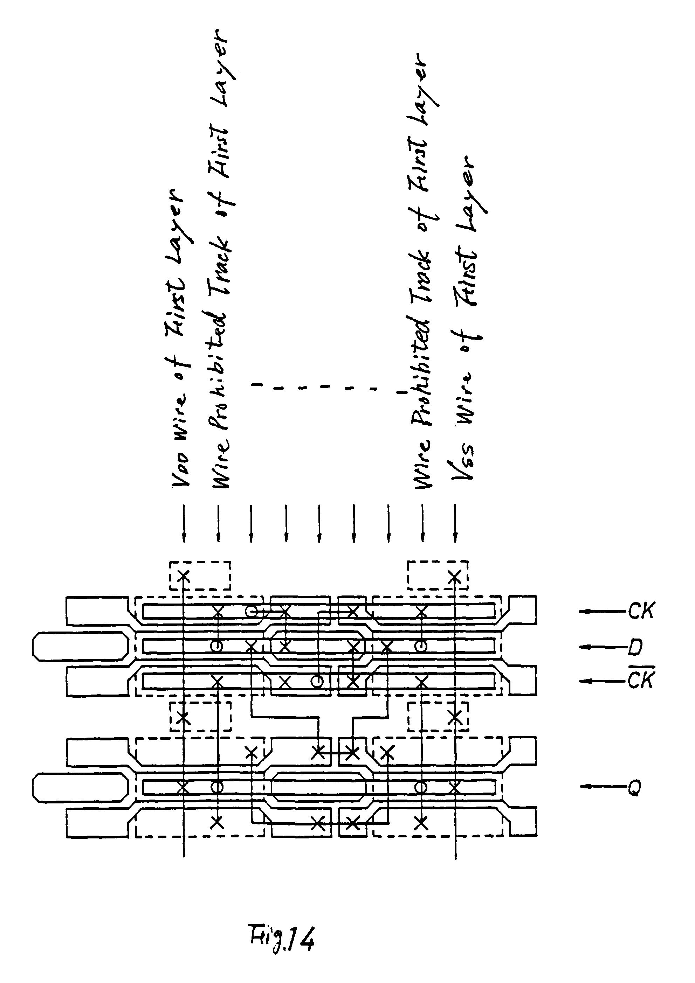

Next, in the unit semiconductor device 22 of the present embodiment, the diagonal wiring among the gates can be carried out as shown in Figure 13, wherein the terminal portion T22 of the gate 24P is connected to the terminal portion T1 of the gate 25N and the terminal portion T22 of the gate 25P to the terminal portion T1 of the gate 24N. As shown in Figure 13, the terminal portion T22 of the gate 24P is connected at its first wire connecting position t1 to the adjacent third wire-junction position P3 of the wire-junction area 28 via an aluminum wire ℓ _{1X1} arranged in X direction, the wire-junction area 28 is connected at its first wire-junction position P1 to the terminal portion T1 of the gate 25N via an aluminum wire ℓ _{1X2} arranged in X direction, and the terminal portion T22 of the gate 25P is connected at its second wire connecting position t12 to the terminal portion T1 of the gate 24N via an aluminum wire ℓ _{1XY} arranged to pass over the second wire-junction position P2 of the area 28 and the second wire connecting position t12 of the terminal portion T22 in this order. The above aluminum wires are all of the first layer.

The above diagonal wiring among the gates can be performed within a space of three-grid length in X direction by three-grid width in Y direction by only the first aluminum layer. In comparison with the unit semiconductor device 12 of Figure 2, although the unit semiconductor device 22 is longer in Y direction by one grid and has an increased area by that amount, it has a ben fit that the passage for the aluminum wire ℓₓ is assured between the laterally adjacent terminal portions. Thus, according to the present embodiment, the first layered wires can easily be distributed to thereby obtain more improved outer wiring feasibility.

Figure 14 illustrates a D flip-flop of Figure 21 which is comprised by the two unit semiconductor devices 22. As can be seen from Figure 14, the layout of the flip-flop is simplified so that the total wiring length is extremely reduced and no prohibited tracks occur in the second layer.

The gates 24P and 25P of the unit device 22 are provided with the terminal portions T22 having the second wire connecting portions t12, respectively. Alternatively, only one of the gates 24P and 25P may be provided with the terminal portion T22 having the second wire connecting position t12 in order to perform the diagonal wiring among the gates by using only the first layered wires, which is apparent from Figure 13.

## Claims

1. A semiconductor device comprising a plurality of unit semiconductor devices (22), each comprising first and second insulated-gate type field-effect transistors (F_{P1}, F_{P2}) of a first conductivity type and third and fourth insulated-gate type field-effect transistors (F_{N1}, F_{N2}) of a second conductivity type, said unit semiconductor devices and transistors being selectively connected by wires to one another to constitute a desired logic circuitry, wherein
the gate electrode (24P) of the first transistor (F_{P1}) is arranged in parallel to that (25P) of the second transistor (F_{P2}) and the gate electrode (24N) of the third transistor (F_{N1}) is arranged in parallel to that (25N) of the fourth transistor (F_{N2}),
the first transistor is disposed adjacent to the third transistor and has a gate terminal portion (T₂₂) of its gate electrode (24P) disposed adjacent to but separated from a gate terminal portion (T₁) of the gate electrode (24N) of the third transistor,
the second transistor is disposed adjacent to the fourth transistor and has a gate terminal portion (T₂₂) of its gate electrode (25P) disposed adjacent to but separated from a gate terminal portion (T₁) of the gate electrode (25N) of the fourth transistor, and
each of the gate terminal portions (T₂₂) of the first and second transistors (F_{P1}, F_{P2}) comprises at least first and second wire connecting portions (t₁, t₁₂),
**characterized in that**
an isolated wire junction region (28) is arranged in an area surrounded by the respective gate terminal portions (T₂₂, T₂₂, T₁, T₁) of said first, second, third and fourth transistors wherein the gate terminal portions of the first and third transistors on the one hand and those of the second and fourth transistors on the other hand lie on opposite sides of the wire junction region and wherein said first and second transistors (F_{P1}, F_{P2}) have a common source or drain region and said third and fourth transistors (F_{N1}, F_{N2}) have a common source or drain region.

2. The device of claim 1 wherein said first wire connecting portions (t₁) of the first and second transistors (F_{P1}, F_{P2}) are arranged on a first line orthogonal to the direction of channel width of these transistors, and the terminal portions (T₁) of the third and fourth transistors (F_{N1}, F_{N2}) are arranged on a second line parallel to the first line.

3. The device of claim 2 wherein said first wire connecting portion (t₁) of the first transistor (F_{P1}) and the terminal portion (T₁) of the third transistor (F_{N1}) are arranged on a third line orthogonal to said first and second lines, and said first wire connecting portion (t₁) of the second transistor (F_{P2}) and the terminal portion (T₁) of the fourth transistor (F_{N2}) are arranged on a fourth line parallel to the third line.

4. The device of claim 3 wherein said second wire connecting portions (t₁₂) of said first and second transistors (F_{P1}, F_{P2}) adjacent to the terminal portions (T₁) of said third and fourth transistors (F_{N1}, F_{N2}), respectively, are arranged on a fifth line parallel to and in between said first and second lines and said wire junction region (28) comprises first, second and third wire junction positions (P₂,P₁,P₃) arranged on said fifth, second and first lines, respectively.

5. The device of claim 4 wherein said first to third wire junction positions (P₂,P₁,P₃) of said wire junction region (28) are arranged on a sixth line parallel to and in between said third and fourth lines.

6. The device of any one of the preceding claims wherein said wire junction region (28) is made from the same material as said gate electrodes.

## Patentansprüche

1. Halbleitervorrichtung mit einer Vielzahl von Einheitshalbleitervorrichtungen (22), von denen jede einen ersten und einen zweiten Isolierschicht-Feldeffekttransistor (F_{P1,} F_{P2}) eines ersten Leitfähigkeitstyps sowie einen dritten und einen vierten Isolierschicht-Feldeffekttransistor (F_{N1}, F_{N2}) eines zweiten Leitfähigkeitstyps aufweist, wobei die Einheitshalbleitervorrichtungen und Transistoren selektiv durch Drähte miteinander verbunden sind, um eine gewünschte logische Schaltung zu bilden, wobei
die Gate-Elektrode (24P) des ersten Transistors (F_{P1}) parallel zu derjenigen (25P) des zweiten Transistors (F_{P2}) angeordnet ist und die Gate-Elektrode (24N) des dritten Transistors (F_{N1}) parallel zu derjenigen (25N) des vierten Transistors (F_{N2}) angeordnet ist,
der erste Transistor neben dem dritten Transistor angeordnet ist und einen Gate-Anschlußabschnitt (T₂₂) seiner Gate-Elektrode (24P) aufweist. der neben einem Gate-Anschlußabschnitt (T₁) der Gate-Elektrode (24N) des dritten Transistors, jedoch von ihm getrennt, angeordnet ist,
der zweite Transistor neben dem vierten Transistor angeordnet ist und einen Gate-Anschlußsbschnitt (T₂₂) seiner Gate-Elektrode (25P) aufweist, der neben einem Gate-Anschlußabschnitt (T₁) der Gate-Elektrode (25N) des vierten Transistors, jedoch von ihm getrennt, angeordnet ist, und
jeder der Gate-Anschlußsbschnitte (T₂₂) des ersten und des zweiten Transistors (F_{P1}, F_{P2}) zumindest einen ersten und einen zweiten Drahtverbindungsabschnitt (t₁, t₁₂) aufweist,
**dadurch gekennzeichnet,** daß
ein isolierter Drahtanschlußbereich (28) in einer Zone angeordnet ist, die von den jeweiligen Gate-Anschlußsbschnitten (T₂₂, T₂₂, T₁, T₁) des ersten, zweiten, dritten und vierten Transistors umgeben ist, wobei die Gate-Anzchlußsbschnitte des ersten und des dritten Transistors einerseits und jene des zweiten und des vierten Transistors andererseits auf entgegengesetzten Seiten des Drahtanschlußbereichs liegen und wobei der erste und der zweite Transistor (F_{P1}, F_{P2}) einen gemeinsamen Source- oder Drain-Bereich sowie der dritte und der vierte Transistor (F_{N1}, F_{N2}) einen gemeinsamen Source- oder Drain-Bereich aufweisen.

2. Vorrichtung nach Anspruch 1, bei der die ersten Drahtverbindungsabschnitte (t₁) des ersten und des zweiten Transistors (F_{P1}, F_{P2}) auf einer zur Richtung der Kanalbreite dieser Transistoren senkrechten ersten Linie angeordnet und die Anschlußabschnitte (T₁) des dritten und des vierten Transistors (F_{N1}, F_{N2}) auf einer zur ersten Linie parallelen zweiten Linie angeordnet sind.

3. Vorrichtung nach Anspruch 2, bei der der erste Drahtverbindungsabschnitt (t₁) des ersten Transistors (F_{P1}) und der Anschlußabschnitt (T₁) des dritten Transistors (F_{N1}) auf einer zur ersten und zur zweiten Linie senkrechten dritten Linie angeordnet und der erste Drahtverbindungsabschnitt (t₁) des zweiten Transistors (F_{P2}) und der Anschlußabschnitt (T₁) des vierten Transistors (F_{N2}) auf einer zur dritten Linie parallelen vierten Linie angeordnet sind.

4. Vorrichtung nach Anspruch 3, bei der die zweiten Drahtverbindungsabschnitte (t₁₂) des ersten und des zweiten Transistors (F_{P1}, F_{P2}) neben den Anschlußabschnitten (T₁) des dritten bzw. des vierten Transistors (F_{N1}, F_{N2}) auf einer fünften Linie angeordnet sind, die parallel zur ersten und zweiten Linie zwischen diesen liegt, und der Drahtanschlußbereich (28) eine erste, eine zweite und eine dritte Drahtanschlußposition (P₂, P₁, P₃) aufweist, die auf der fünften, zweiten bzw. ersten Linie angeordnet sind.

5. Vorrichtung nach Anspruch 4, bei der die erste bis dritte Drahtanschlußposition (P₂, P₁, P₃) des Drahtanschlußbereichs (28) auf einer sechsten Linie angeordnet sind, die parallel zur dritten und vierten Linie zwischen diesen liegt.

6. Vorrichtung nach einem der vorhergehenden Ansprüche, bei der der Drahtanschlußbereich (28) aus demselben Material wie die Gate-Elektroden hergestellt ist.

## Revendications

1. Dispositif à semi-conducteur comprenant une pluralité de dispositifs (22) à semi-conducteur élémentaires, comprenant chacun des premier et second transistors (F_{P1}, F_{P2}) à effet de champ du type à grille isolée d'un premier type de conductivité et des troisième et quatrième transistors (F_{N1}, F_{N2}) à effet de champ du type à grille isolée d'un second type de conductivité, les dispositifs élémentaires à semi-conducteur et les transistors étant sélectivement connectés les uns aux autres par des conducteurs afin de constituer un circuit logique souhaité, dans lequel :
l'électrode (24P) de grille du premier transistor (F_{P1}) est agencée parallèlement à celle (25P) du second transistor (F_{P2}) et l'électrode de grille (24N) du troisième transistor (F_{N1}) est agencée parallèlement à celle (25N) du quatrième transistor (F_{N2}),
le premier transistor est disposé de façon adjacente au troisième transistor et a une partie (T₂₂) formant borne de grille de son électrode (24P) de grille qui est disposée de façon adjacente mais séparée d'une partie (T₁) formant borne de grille de l'électrode (24N) de grille du troisième transistor,
le second transistor est disposé de façon adjacente au quatrième transistor et a une partie (T₂₂) formant borne de grille de son électrode (25P) de grille qui est disposée de façon adjacente mais séparée d'une partie (T₁) formant borne de grille de l'électrode (25N) de grille du quatrième transistor, et
chacune des parties (T₂₂) formant bornes de grille des premier et second transistors (F_{P1}, F_{P2}) comprend au moins des première et seconde parties (t₁, t₁₂) de connexion de conducteurs,
caractérisé en ce que
une région (28) de jonction de conducteurs isolée est agencée dans une zone entourée par les parties (T₂₂, T₂₂, T₁, T₁) formant bornes de grille respectives des premier, second, troisième et quatrième transistors, les parties formant bornes de grille des premier et troisième transistors, d'une part, et celles des second et quatrième transistors, d'autre part, se situant sur des côtés opposés de la région de jonction de conducteurs, et lesdits premier et second transistors (F_{P1}, F_{P2}) ont une région de source ou de drain commune et les troisième et quatrième transistors (F_{N1}, F_{N2}) ont une région de source ou de drain commune.

2. Dispositif suivant la revendication 1, dans lequel les premières parties (t₁) de connexion de conducteurs des premier et second transistors (F_{P1}, F_{P2}) sont agencées sur une première ligne orthogonale à la direction de la largeur de canal de ces transistors, et les parties (T₁) formant bornes des troisième et quatrième transistors (F_{N1}, F_{N2}) sont agencées sur une seconde ligne parallèle à la première ligne.

3. Dispositif suivant la revendication 2, dans lequel la première partie (t₁) de connexion de conducteurs du premier transistor (F_{P1}) et la partie (T₁) formant borne du troisième transistor (F_{N1}) sont agencées sur une troisième ligne orthogonale aux première et seconde lignes, et la première partie (t₁) de connexion de conducteurs du second transistor (F_{P2}) et la partie (T₁) formant borne du quatrième transistor (F_{N2}) sont agencées sur une quatrième ligne parallèle à la troisième ligne.

4. Dispositif suivant la revendication 3, dans lequel les secondes parties (t₁₂) de connexion de conducteurs des premier et second transistors (F_{P1}, F_{P2}) adjacentes aux parties (T₁) formant bornes des troisième et quatrième transistors (F_{N1}, F_{N2}) sont respectivement agencées sur une cinquième ligne parallèle aux première et seconde lignes, et située entre elles, et la région (28) de jonction de conducteurs comprend des première, seconde et troisième positions (P₂, P₁, P₃) de jonction de conducteurs respectivement agencées sur les cinquième, seconde et première lignes.

5. Dispositif suivant la revendication 4, dans lequel les première à troisième positions (P₂, P₁, P₃) de jonction de conducteurs de la région (28) de jonction de conducteurs sont agencées sur une sixième ligne parallèle aux troisième et quatrième lignes, et située entre celles-ci.

6. Dispositif suivant l'une quelconque des revendications précédentes, dans lequel la région (28) de jonction de conducteurs est faite du même matériau que les électrodes de grille.
